(19) Europäisches Patentamt
European Patent Office
Office européen des brevets

(11) **EP 1 884 876 A2**

(12) **EUROPEAN PATENT APPLICATION**

(43) Date of publication:
**06.02.2008 Bulletin 2008/06**

(51) Int Cl.:
***G06F 17/14*** *(2006.01)*

(21) Application number: **07253008.2**

(22) Date of filing: **31.07.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: **01.08.2006 US 497947**

(71) Applicant: **Textronix Inc.**
**Beaverton, Oregon 97077-0001 (US)**

(72) Inventor: **Gee, Edward C.**
**Camas, Washington 98607 (US)**

(74) Representative: **Want, Clifford James**
**Harrison Goddard Foote**
**40-43 Chancery Lane**
**London WC2A 1JA (GB)**

(54) **Systems and methods for time domain to frequency domain conversion using frequency shifting**

(57)     A method for time domain to frequency domain conversion is described. Time-domain input data is obtained. The input data is converted from the time domain to the frequency domain to provide frequency-domain data. Frequency-shifted time-domain data is produced. The frequency shifted time-domain data is converted from the time domain to the frequency domain to provide frequency-shifted frequency-domain data. The frequency-domain data is combined with the frequency-shifted frequency-domain data to produce combined frequency-domain data. The frequency-domain data is provided for further processing by a test and measurement system.

400

402 — Obtain an input signal in the time domain

404 — Digitize the input signal to provide a digital input signal

406 — Adjust tunable frequency conversion stage

408 — Shift the frequency of the digital input signal using the tunable frequency conversion stage

410 — Convert from the time-domain to the frequency domain

412 — Use the frequency domain data to provide a graphical display to a user

**FIG. 4**

EP 1 884 876 A2

Printed by Jouve, 75001 PARIS (FR)

**Description**

TECHNICAL FIELD

The present invention relates generally to test equipment. More specifically, the present invention relates to systems and methods for time domain to frequency domain conversion using frequency shifting.

BACKGROUND

Technological innovation in Radio Frequency (RF) devices has accelerated steadily over the last several decades and continues to do so today. To resist interference, avoid detection, and improve capacity, modem radar systems and commercial communications networks have become extremely complex, and both typically employ sophisticated combinations of RF techniques such as bursting, frequency hopping, code division multiple access, and adaptive modulation. Designing these types of advanced RF equipment and successfully integrating them into working systems are extremely complicated tasks.

At the same time, the increasingly widespread success of cellular technology and wireless data networks has caused the cost of basic RF components to plummet. This has enabled manufacturers outside of the traditional military and communications realms to embed relatively simple RF devices into all sorts of commodity products. RF transmitters have become so pervasive that they can be found in almost any imaginable location: consumer electronics in homes, medical devices in hospitals, industrial control systems in factories, and even tracking devices implanted underneath the skin of livestock, pets, and people.

As RF signals have become ubiquitous in the modem world, so too have problems with interference between the devices that generate them. Products such as mobile phones that operate in a licensed spectrum must be designed not to transmit RF energy into adjacent frequency channels, which is especially challenging for complex multi-standard devices that switch between different modes of transmission and maintain simultaneous links to different network elements. Simpler devices that operate in unlicensed frequency bands must also be designed to function properly in the presence of interfering signals, and government regulations often dictate that these devices are only allowed to transmit in short bursts at low power levels.

The transition to digital broadcast technologies has created new business challenges and requirements for video and audio monitoring, increasing the need for tools that quickly verify the quality of digital signals. Monitoring tools are used to detect and diagnose problems affecting the quality of digital video and audio transmissions. Effective monitoring tools reduce time and effort in fault detection, problem diagnosis and failure recovery.

Wireless data networks allow systems to share information through wireless technologies. A wireless LAN (local area network) is one example of a wireless data network. A wireless LAN typically transmits over the air in the 2.4 GHz or 5 GHz frequency band. A wireless access point is wired into the LAN and enables systems to connect wirelessly to the LAN though a radio frequency. As wireless data networks continue to advance, and as other technologies that use RF signals are put in place, the likelihood of interference or other problems with the RF signals increases. The use of effective monitoring tools or test equipment helps detect problems in wireless data networks.

The increasing rate of demand for more efficient methods of communicating with others has led to the increased use of mobile telecommunications devices, such as cellular telephones. Cellular telephones provide users the ability to communicate by telephone without the restrictions of a wire-based telephone. Some cellular telephones also provide users the ability to engage in numerous online services. There are many different providers of cellular services, as well as many different kinds of technologies used in cellular telephones. Some of the cellular telephone technologies include TDMA (Time Division Multiple Access), CDMA (Code Division Multiple Access) and GSM (Global System for Mobile Communications). Regardless of the specific technology being used, the ability to diagnose and fix problems is important to the continued use and advancement of cellular technologies.

In order to overcome these evolving challenges mentioned above, it is crucial for today's engineers and scientists to be able to reliably detect and characterize RF signals that change over time, something not easily done with traditional measurement tools. In analyzing signals, engineers and scientists often view different kinds of plots, graphs or other displays of the data on different kinds of test equipment. Some of the plots or graphs may be displaying signals in the time domain, while others may be displaying signals in the frequency domain. In some cases there are fewer data points than are available on the display of the test equipment. Interpolation has heretofore been used to fill up the display points in between the available data output points. However, interpolation has a number of shortcomings and imperfections.

As shown from the above discussion, there is a need for systems and methods that will improve the ability to analyze and display electronic signals. Benefits may be realized by providing increased functionality to process, analyze and display electronic signals. Benefits may further be realized by providing this increased functionality.

## BRIEF DESCRIPTION OF THE DRAWINGS

Exemplary embodiments of the invention will become more fully apparent from the following description and appended claims, taken in conjunction with the accompanying drawings. Understanding that these drawings depict only exemplary embodiments and are, therefore, not to be considered limiting of the invention's scope, the exemplary embodiments of the invention will be described with additional specificity and detail through use of the accompanying drawings in which:

Figure 1 is a frequency-domain plot of the prior art illustrating an actual sine wave and interpolation between the frequency-domain data points obtained for that sine wave;

Figure 2 is a frequency-domain plot of the prior art illustrating a noise signal and interpolation between the frequency-domain data points obtained for that signal;

Figure 3 is a block diagram of a system for time domain to frequency domain conversion through the use of iterative frequency shifting;

Figure 4 is a flow diagram of an embodiment of a method for time domain to frequency domain conversion through the use of iterative frequency shifting;

Figure 5 is a block diagram of another embodiment of a system for time domain to frequency domain conversion through the use of iterative frequency shifting;

Figure 6 is a general hardware block diagram of an embodiment of test equipment being used to implement the present systems and methods;

Figure 7 is a general block diagram of an embodiment of a real-time spectrum analyzer being used to implement the present systems and methods;

Figure 8 is a frequency-domain plot illustrating four slightly different frequency sine waves;

Figure 9 is a frequency spectrum illustrating the samples being shifted back to the original frequency and resultant single tone; and

Figure 10 is a frequency spectrum illustrating the display for a noise-like signal.

## DETAILED DESCRIPTION

A method for time domain to frequency domain conversion is described. Time-domain input data is obtained. The input data is converted from the time domain to the frequency domain to provide frequency-domain data. Frequency-shifted time-domain data is produced. The frequency shifted time-domain data is converted from the time domain to the frequency domain to provide frequency-shifted frequency-domain data. The frequency-domain data is combined with the frequency-shifted frequency-domain data to produce combined frequency-domain data. The frequency-domain data is provided for further processing by a test and measurement system.

In one embodiment, producing frequency-shifted time-domain data comprises shifting the frequency of the time-domain input data. A numerically controlled oscillator may be used to produce the frequency-shifted time-domain data. Producing frequency-shifted time-domain data may be accomplished by multiplying the input data by an output from the numerically controlled oscillator. Additionally, producing frequency-shifted time-domain data may include shifting the frequency of a second set of time-domain input data. The second set of time-domain input data may include a portion of the time-domain input data.

An input signal may be digitized to obtain the time-domain input data. In one embodiment, obtaining the time-domain input data may include reading the data in from a computer-readable file.

Converting from the time domain to the frequency domain may be accomplished using a Discrete Fourier Transform.

The frequency shifted input data may be windowed before converting the frequency shifted input data from the time domain to the frequency domain.

Other embodiments may iteratively perform the producing frequency-shifted time-domain data, converting the frequency-shifted time-domain data, and combining the frequency-domain data with frequency-shifted frequency-domain data. The combined frequency-domain data may be stored as frequency domain data.

Producing frequency-shifted time-domain data may include shifting the frequency by a frequency offset. The frequency offset may change with each iteration. In one embodiment, the frequency offset is pseudo-random. The frequency offset may be determined based on a desired number of data points to be added in between frequency bins.

In some embodiments, a number of sets of frequency-shifted frequency-domain data are produced. All or any portion of the frequency-domain data may be used to perform the further processing.

A plurality of producing frequency-shifted time-domain data steps may be performed to produce a plurality of frequency-shifted time-domain data sets. The plurality frequency-shifted time-domain data sets may be converted to produce a plurality of frequency shifted frequency domain data sets.

The further processing may include providing a display on the test and measurement system. Additionally, further processing may include performing measurements using the frequency-domain data.

An apparatus for time domain to frequency domain conversion is described. The apparatus includes a processor and memory in electronic communication with the processor. Obtaining instructions are stored in the memory and are executable by the processor to obtain time-domain input data. Converting instructions are stored in the memory and are executable by the processor to convert the input data from the time domain to the frequency domain to provide frequency-domain data. Producing instructions are stored in the memory and are executable by the processor to produce frequency-shifted time-domain data. Second converting instructions are stored in the memory and are executable by the processor to convert the frequency shifted time-domain data from the time domain to the frequency domain to provide frequency-shifted frequency-domain data. Combining instructions are stored in the memory and are executable by the processor to combine the frequency-domain data with the frequency-shifted frequency-domain data to produce combined frequency-domain data. Providing instructions are stored in the memory and are executable by the processor to provide the frequency-domain data for further processing by a test and measurement system.

A real-time spectrum analyzer for time domain to frequency domain conversion is also described. The real-time spectrum analyzer includes a processor and memory in electronic communication with the processor. An input interface is included for continuously obtaining an input signal. An analog to digital converter is included for continuously converting the input signal into input data. The real-time spectrum analyzer also includes at least one digital signal processor for performing digital signal processing functions in electronic communication with the processor. Obtaining instructions are stored in the memory and are executable by the processor to obtain time-domain input data. Converting instructions are stored in the memory and are executable by the processor to convert the input data from the time domain to the frequency domain to provide frequency-domain data. Producing instructions are stored in the memory and are executable by the processor to produce frequency-shifted time-domain data. Second converting instructions are stored in the memory and are executable by the processor to convert the frequency shifted time-domain data from the time domain to the frequency domain to provide frequency-shifted frequency-domain data. Combining instructions are stored in the memory and are executable by the processor to combine the frequency-domain data with the frequency-shifted frequency-domain data to produce combined frequency-domain data. Providing instructions are stored in the memory and are executable by the processor to provide the frequency-domain data for further processing by a test and measurement system.

An apparatus for time domain to frequency domain conversion is also described. The apparatus includes processing logic and memory in electronic communication with the processing logic. Obtaining logic is included and operable to obtain time-domain input data. Converting logic is included and operable to convert the input data from the time domain to the frequency domain to provide frequency-domain data. Producing logic is included and operable to produce frequency-shifted time-domain data. Second converting logic is included and operable to convert the frequency shifted time-domain data from the time domain to the frequency domain to provide frequency-shifted frequency-domain data. Combining logic is included and operable to combine the frequency-domain data with the frequency-shifted frequency-domain data to produce combined frequency-domain data. Providing logic is included and operable to provide the frequency-domain data for further processing by a test and measurement system.

An embodiment may also include a display screen and display logic. The display logic is operable to use the frequency-shifted frequency-domain data to provide a display on the display screen of the apparatus.

Various embodiments of the invention are now described with reference to the Figures, where like reference numbers indicate identical or functionally similar elements. The embodiments of the present invention, as generally described and illustrated in the Figures herein, could be arranged and designed in a wide variety of different configurations. Thus, the following more detailed description of several exemplary embodiments of the present invention, as represented in the Figures, is not intended to limit the scope of the invention, as claimed, but is merely representative of the embodiments of the invention.

The word "exemplary" is used exclusively herein to mean "serving as an example, instance, or illustration." Any embodiment described herein as "exemplary" is not necessarily to be construed as preferred or advantageous over other embodiments. While the various aspects of the embodiments are presented in drawings, the drawings are not necessarily drawn to scale unless specifically indicated.

Many features of the embodiments disclosed herein may be implemented as computer software, electronic hardware, or combinations of both. To clearly illustrate this interchangeability of hardware and software, various components will be described generally in terms of their functionality. Whether such functionality is implemented as hardware or software depends upon the particular application and design constraints imposed on the overall system. Skilled artisans may implement the described functionality in varying ways for each particular application, but such implementation decisions should not be interpreted as causing a departure from the scope of the present invention.

Where the described functionality is implemented as computer software, such software may include any type of computer instruction or computer executable code located within a memory device and/or transmitted as electronic signals over a system bus or network. Software that implements the functionality associated with components described herein may comprise a single instruction, or many instructions, and may be distributed over several different code segments, among different programs, and across several memory devices.

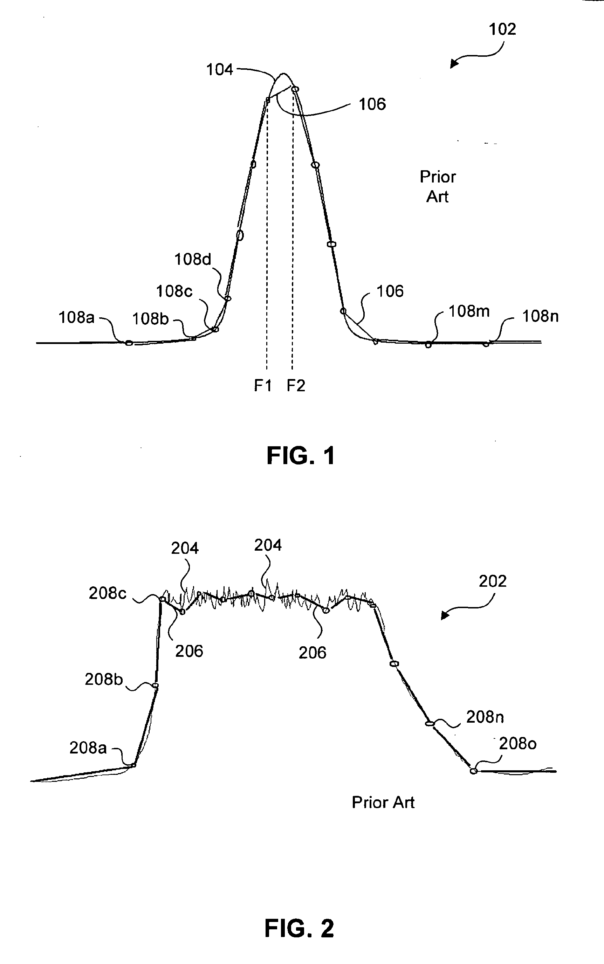

A display of time-to-frequency conversion output data may have fewer points than are available in the display mechanism. One example of a time-to-frequency conversion process is an FFT (Fast Fourier Transform). Interpolation has heretofore been used to fill up the display points in between the available frequency data output points. Examples of interpolation will be shown in Figures 1 and 2 below.

The systems and methods herein frequency shift time-domain data and then perform a frequency transform to produce the needed intermediate points from actual data instead of using a traditional interpolation method that predicts or guesses what the data should have been. These systems and methods are typically used in applications where a large number of conversions from time-domain data to frequency-domain data are processed with the intention of having a fast-updating display of frequency data (such as a spectrum analyzer).

In the case where fast updates are required, each update may have fewer data points than the display device has available. There are many mathematical methods in common use for predicting what the missing data might have been. One of these is the straight-line interpolation wherein a straight line (vector) is drawn on the display between each data point and the next available data point.

Figure 1 is a frequency-domain plot 102 of the prior art illustrating an actual sine wave 104 and interpolation 106 between the frequency-domain data points 108a-n obtained for that sine wave 104. Each of the commonly-used interpolation methods has its own varying accuracy limitations when re-creating a frequency plot of a single-tone sine wave, as is illustrated in Figure 1. The single-tone sine wave 104 is shown on the frequency spectrum. The data points 108 obtained from sampling and a time domain to frequency domain conversion are shown. The accuracy and limitation of this particular method of interpolation may be shown by examining the waveforms 104, 106 in between a first frequency, F1, and a second frequency, F2. The actual sine wave 104 in between F1 and F2 shows the actual curve of the sine wave 104. However the interpolation 106 in between F1 and F2 loses the accuracy of the peak of the sine wave and chops off the peak of the wave.

The systems and methods herein may be used to provide additional data points that may be used for different reasons including, but not limited to, providing a display on a test instrument, performing measurements, etc. Some possible measurements may include a power measurement, a frequency measurement, a frequency difference measurement, etc. There are many different kinds of measurements that may be performed on the additional data points provided by the systems and methods herein.

Figure 2 is a frequency-domain plot 202 of the prior art illustrating a noise signal 204 and interpolation 206 between the frequency-domain data points 208a-o obtained for that signal 204. The noise signal 204 is shown on the frequency spectrum 202. The data points 208 obtained from sampling and a time domain to frequency domain conversion are shown. As illustrated, this interpolation method lacks the ability to re-create the correct amplitude distribution when the signal being measured is noise as in Figure 2 (or other noise-like signals). The Gaussian distribution of simple noise, or any other created distribution of a particular signal (such as digitally modulated signals) cannot be properly displayed. The straight-line interpolation 206 loses the amplitude distribution that was present in the noise signal 204.

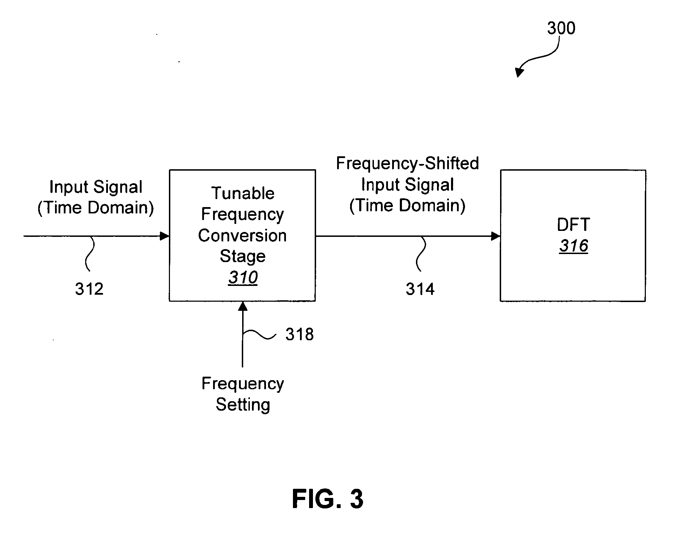

Figure 3 is a block diagram of a system 300 for time domain to frequency domain conversion through the use of iterative frequency shifting. This system 300 uses a tunable frequency conversion stage 310. An input signal 312 in the time domain is fed into the tunable frequency conversion stage 310. The tunable frequency conversion stage 310 shifts the frequency of the input signal 312 to provide a frequency shifted input signal 314 which is still in the time domain. The time-domain frequency shifted input signal 314 is then converted from the time domain into the frequency domain by a Discrete Fourier Transform (DFT) 316. The tunable frequency conversion stage 310 is tuned to different frequencies for each successive set of data on which a DFT 316 is performed. The tunable frequency conversion stage 310 is tuned by a frequency setting 318. As the frequency setting 318 is changed, the frequency of the output signal 314 also changes. By shifting the input signal 312 to many different frequencies, the system 300 is able to obtain different data points on a frequency spectrum plot to thereby fill in points on the spectrum curve with actual data rather than having to interpolate between data points as discussed in relation to Figures 1 and 2.

The technical specifications and the implementation of the display being used may influence how the additional data points are used. For example, depending on the particular display implementation, the additional data points may be used in the horizontal axis, the vertical axis, a combination of both, etc.

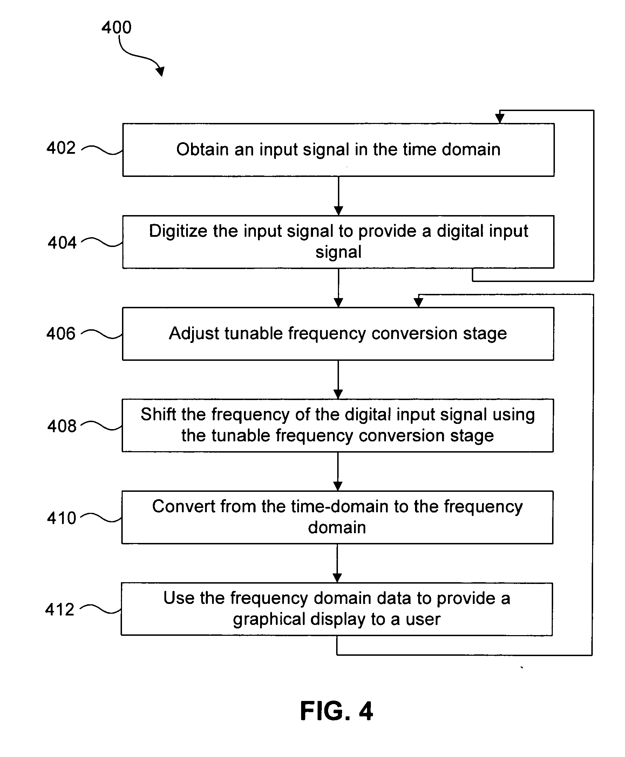

Figure 4 is a flow diagram of an embodiment of a method 400 for time domain to frequency domain conversion through the use of iterative frequency shifting. An input signal in the time domain is obtained 402. Typically the input signal is continuously acquired. However, the present systems and methods may be used with data that is not continuously being fed into the system. For example, the present systems and methods may operate on data stored on a storage device that is not currently and continuously being acquired.

The input signal is digitized 404 to provide a digital input signal. At some point in this method the tunable frequency conversion stage 310 is tuned 406 to a desired frequency to provide additional data points as desired. The digital input signal is then frequency shifted 408 by the tunable frequency conversion stage 310. If, in a particular embodiment, it was desired to not shift the frequency, the embodiment may set the shift to zero so that no frequency shift is accomplished.

The time-domain frequency shifted input signal is then converted 410 from the time domain into the frequency domain by a Discrete Fourier Transform (DFT). In one embodiment an FFT is used for the time domain to frequency domain conversion. The DFT may be implemented as a windowed FFT, a Chirp-Z transform (CZT), etc. The frequency domain data can then be displayed 412 by a piece of test equipment or other computing device.

The method 400 shown in Figure 4 may continue to repeat. Typically the input signal is continuously fed into the tunable frequency conversion stage 310. The tunable frequency conversion stage 310 is tuned to different frequencies for each successive set of data on which an FFT is performed. By shifting the input signal to many different frequencies, the system is able to obtain different data points on a frequency spectrum plot to thereby fill in points on the spectrum curve with actual data rather than having to interpolate between data points as discussed in relation to Figures 1 and 2.

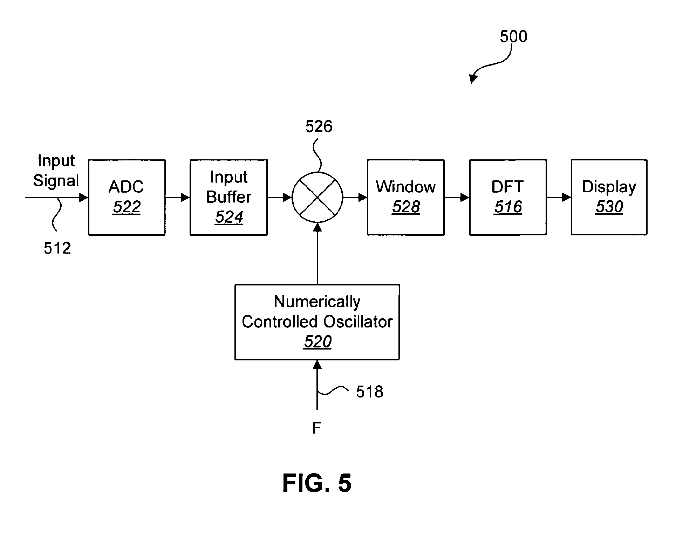

Figure 5 is a block diagram of another embodiment of a system 500 for time domain to frequency domain conversion through the use of iterative frequency shifting. In this embodiment 500, a numerically controlled oscillator 520 is used to accomplish the tunable frequency conversion stage 310. The sequence of frequency stepping may be modified. For example, although one embodiment may use a linear frequency sequence, another embodiment may use a pseudo-random sequence.

An input signal 512 in the time domain is digitized by an analog to digital converter (ADC) 522 and placed into an input buffer 524. In one embodiment the input buffer 524 is a circular input buffer. In a circular input buffer the latest sample is written over the top of the oldest sample still in the input buffer. Depending on the sample rate and the transform rate, it is possible that some of the data in the input buffer will not be used. Additionally, the data in the input buffer may be reused in successive transforms.

The data stream from the input buffer 524 is then multiplied 526 by the signal from the numerically controlled oscillator 520 to shift the frequency of the input signal 512 to provide a frequency shifted input signal which is still in the time domain. The numerically controlled oscillator 520 slightly changes the frequency of the incoming signal based on a setting 518 for each successive acquisition that will be converted from time data to frequency data. In one embodiment this is linearly stepped or "swept" periodically during the acquisition of the data for any single display. In one embodiment this is a complex input data stream being multiplied by a complex NCO (numerically controlled oscillator), i.e. $y(n) = x(n) \times e^{j\omega n}$.

The frequency shifted input signal in then windowed 528. The time-domain frequency shifted input signal is then converted from the time domain into the frequency domain by a Discrete Fourier Transform (DFT) 516, which is typically an FFT. The data provided by the DFT 516 may then be displayed on the display screen 530 of test equipment and/or a computing device.

The Fast Fourier Transform (FFT) is typically an important part of test equipment and/or spectrum analyzers. Conceptually, FFT processing can be considered as passing a signal through a bank of parallel filters with equal frequency resolution and bandwidth. The FFT output is generally complex-valued. For spectrum analysis, the amplitude of the complex result is usually of most interest.

The FFT process starts with properly decimated and filtered base-band I and Q components, which form the complex representation of the signal with I as its real part and Q as its imaginary part. In FFT processing, a set of samples of the complex I and Q signals are processed at the same time. The FFT acts on a sampled time signal and produces a sampled frequency function with the same length. The number of samples in the FFT, generally a power of 2, is also called the FFT size. For example, 1024 point FFT can transform 1024 I and 1024 Q samples into 1024 complex frequency-domain points.

The amount of time represented by the set of samples upon which the FFT is performed will be referred to as the frame length. The frame length is the product of the FFT size and the sample period. Since the calculated spectrum is the frequency representation of the signal over the duration of the frame length, temporal events cannot be resolved within the frame length from the corresponding spectrum. Therefore, the frame length is the time resolution of the FFT process.

The frequency domain points of FFT processing are often called FFT bins. Therefore, the FFT size is equal to the number of bins in one FFT frame. Those bins are equivalent to the individual filter output in the previous mention of parallel filters. All bins are spaced equally in frequency. Two spectral lines closer than the bin width cannot be resolved. The FFT frequency resolution is therefore the width of each frequency bin, which is equal to the sample frequency divided by the FFT size. Given the same sample frequency, a larger FFT size yields finer frequency resolution. With a sample rate of 25.6 MHz and an FFT size of 1024, the frequency resolution is 25 kHz. Frequency resolution can be improved by increasing the FFT size or by reducing the sampling frequency.

There is an assumption inherent in the mathematics of Discrete Fourier Transforms and FFT analysis that the data to be processed is a single period of a periodically repeating signal. Typically, there will be discontinuities between successive frames because of this assumption. These artificial discontinuities generate spurious responses not present in the original signal, which can make it impossible to detect small signals in the presence of nearby large ones. This effect is called spectral leakage.

The windowing 528 of Figure 5 to an FFT frame before FFT processing is performed reduces the effects of spectral leakage. The window functions usually have a bell shape. There are numerous window functions available. Multiplying the FFT frame by the window function reduces the discontinuities at the ends of the frame.

With this brief discussion of signal processing, and referring again to Figure 5, shifting the frequency of the input signal allows the system to pick up the points in between frequency bins. Without the present system and methods, there would not be data in between the frequency bins and an interpolation, similar to that shown in Figures 1 and 2, would have to be performed. With the present systems and methods additional data points are obtained in between the frequency bins. Thus the present system helps keep a random signal distribution looking correct, which is not the case with the linear interpolation shown in Figures 1 and 2.

To determine the granularity, or frequency step size, of the numerically controlled oscillator 520, the number of additional data points desired needs to be considered. For example, take two consecutive bins, such as F1 and F2 of Figure 1. The system and/or designer would need to decide how many additional data points are needed in between the two bins. A general equation that may be used to determine the frequency shifting step size is shown below in Equation 1.

$$F\_StepSize = \frac{F2 - F1}{New\_Bins\_Desired} \qquad \textbf{Equation 1.}$$

As an example, if F2 was 60 Mhz, and F1 was 50 Mhz, and if the number of new bins desired was 10, the frequency step size for the numerically controlled oscillator 520 would be 1 Mhz.

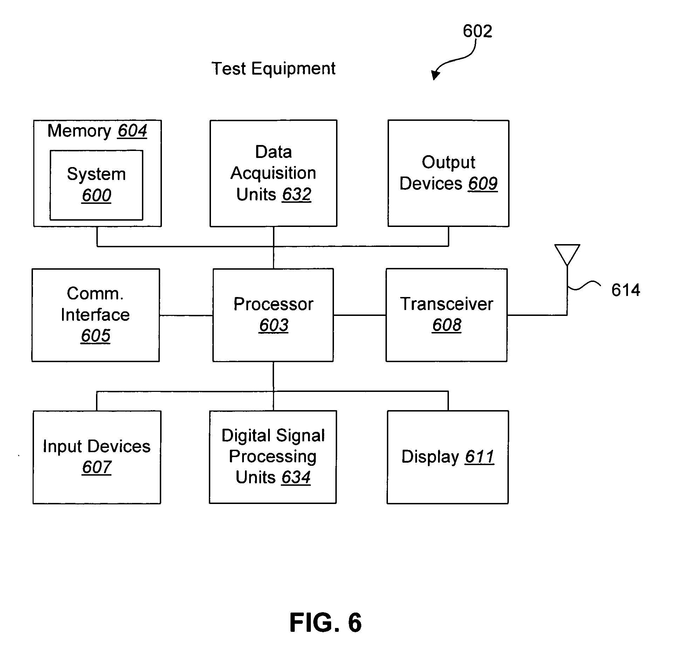

Figure 6 is a general hardware block diagram of an embodiment of test equipment 602 as part of a system for time domain to frequency domain conversion through the use of iterative frequency shifting. Various kinds of test equipment 602 may be used with the systems and methods herein including, but not limited to, oscilloscopes, logic analyzers, video test equipment, network management and diagnostic equipment, real-time spectrum analyzers, etc.

Test equipment 602 may be referred to as a test and measurement system. A test and measurement system is any system adapted to provide testing, measurement, including analysis, or both. A modem test and measurement system may be implemented as a stand alone instrument, an application running on a general purpose computer having the ability to acquire signals from connected hardware, or from data files provided by remote hardware, or a combination of the above.

The test equipment 602 may include a processor 603, memory 604, a communications interface 605, multiple input devices 607, multiple output devices 609 and a display 611. The processor 603 may also be referred to as a CPU. The processor 603 may be embodied as a microprocessor, a microcontroller, a programmable gate array or integrated circuit, a digital signal processor (DSP) or other device known in the art. The processor 603 typically performs logical and arithmetic operations based on program instructions, or logical definitions, stored within the memory 604 or circuits contained within the processor 603.

In one embodiment a Field Programmable Gate Array (FPGA) may be used as the processor 603. An FPGA provides the ability of being programmed in the field. An FPGA is also typically faster in processing than a general purpose processor. The programming of an FPGA herein may be referred to as programming, instructions, logic, operations, executable code, and the like.

Display devices 611 used with embodiments disclosed herein may utilize any suitable image projection technology, such as a cathode ray tube (CRT), liquid crystal display (LCD), light-emitting diode (LED), gas plasma, electroluminescence, or the like. The display 611 may include a display controller. Alternatively a display controller may be included separately. The display controller may be used to convert data stored in the memory 604 into text, graphics, and/or moving images (as appropriate) shown on the display device 611.

The memory 604 provides instructions and data to the processor 603. A portion of the memory 604 may also include non-volatile random access memory (NVRAM). As used herein, the term "memory" 604 is broadly defined as any electronic component capable of storing electronic information, and may be embodied as read only memory (ROM), random access memory (RAM), magnetic disk storage media, optical storage media, flash memory devices in RAM, on-board memory included with the processor 603, EPROM memory, EEPROM memory, registers, etc. The memory 604 typically stores program instructions and other types of data.

The memory may be programmed with instructions to implement a system 600 for time domain to frequency domain conversion through the use of iterative frequency shifting. These instructions for this system 600 may be executed by the processor 603 to implement the systems and methods herein. Other test programs may be used to process and analyze the data obtained by the piece of test equipment 602.

A piece of test equipment 602 typically also includes one or more input devices 607 and one or more output devices 609. Examples of different kinds of input devices 607 include a keyboard, keypad, switches, knobs, mouse, microphone, remote control device, button, joystick, trackball, touchpad, lightpen, sensors, etc. Examples of different kinds of output devices 609 may include an LCD screen, a speaker, printer, etc.

A transceiver 608 may be included to allow the reception and/or transmission of data by the test equipment 602. An antenna 614 may be included and in communication with the transceiver 608.

The test equipment 602 may also include one or more communication interfaces 605 for communicating with other electronic devices. The communication interfaces 605 may be based on wired communication technology, wireless communication technology, or both. Examples of different types of communication interfaces 605 include a serial port, a parallel port, a Universal Serial Bus (USB), an Ethernet adapter, an IEEE 1394 bus interface, a small computer system interface (SCSI) bus interface, an infrared (IR) communication port, a Bluetooth wireless communication adapter, a ZigBee wireless communication adapter, WLAN, an ultra wideband wireless communication adapter, and so forth.

One or more data acquisition units 632 are included in the test equipment 602 to acquire data for capture and analysis. The data acquisition units 632 may include analog to digital converters, filters, amplifiers, etc., as needed to capture and store the data. The data acquired by the data acquisition units 632 is stored in the memory 604.

Digital signal processing units 634 may also be included in the test equipment 602 to perform various kinds of digital signal processing on any acquired data (e.g., windowing, FFT, etc.). The processor 603 has the ability to perform some data processing, but in some environments faster processing is required. Dedicated digital signal processing units 634 can usually provide significant performance increases over what the processor 603 can provide.

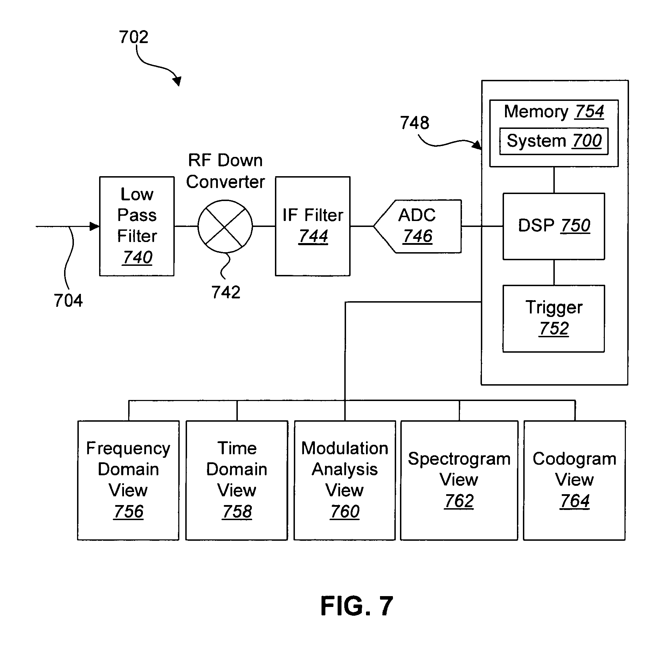

Figure 7 is a general block diagram of an embodiment of a real-time spectrum analyzer 702 being used to implement a system 700 for time domain to frequency domain conversion through the use of iterative frequency shifting, as described herein.

The real-time spectrum analyzer 702 is designed to address the measurement challenges associated with transient and dynamic RF signals. The real-time spectrum analyzer 702 has the ability to trigger on an RF signal, capture it into memory, and analyze it in multiple domains. This makes it possible to reliably detect and characterize RF signals that change over time.

The input signal 704 that is to be analyzed is sent through a low pass filter 740 after which it is down-converted by an RF down-converter 742 to a fixed Intermediate Frequency (IF) that is related to the maximum real-time bandwidth of the real-time spectrum analyzer 702. This RF front-end can be tuned across the entire frequency range of the instrument 702.

The signal is then filtered by an IF filter 744 , digitized by the Analog to Digital Converter (ADC) 746, and passed to the DSP engine 748 that manages the instrument's digital signal processing 750, triggering 752, and memory 754, and analysis functions.

The memory 754 includes program instructions for a system 700 for time domain to frequency domain conversion through the use of iterative frequency shifting. This program 700 may be executed by the DSP engine 748.

The DSP engine 748 enables the real-time spectrum analyzer 702 to provide a user with many different and useful views of the input signal. A frequency domain view 756 may be provided, as well as a time domain view 758. Furthermore, views of modulation analysis 760 may be provided. A spectrogram is a frequency versus time versus amplitude display where the frequency is represented on the x-axis and time on the y-axis. The power is typically expressed by the color. A spectrogram view 762 may be provided. The analyzer 702 may also provide a codogram view 764. A codogram view 764 is a code channel versus time versus power display where the CDMA code channel is represented on the x-axis and time respectively on the y-axis. The power level is expressed by the color.

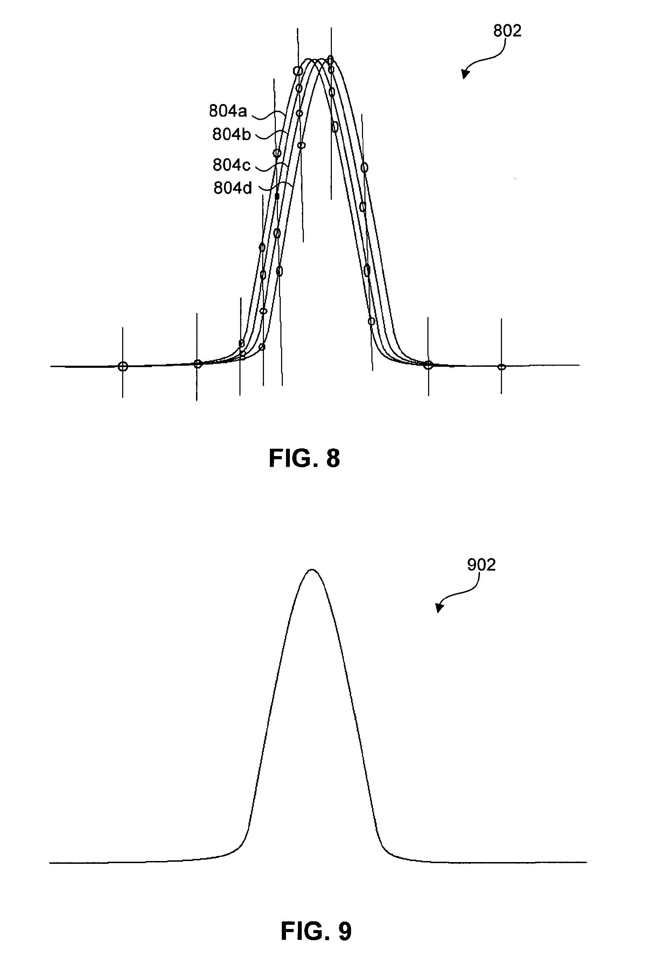

Referring now to Figure 8, one possible implementation of shifting frequencies is illustrated in a frequency spectrum plot 802. Figure 8 shows four slightly different frequencies 804a, 804b, 804c, 804d. As shown, the data points are different on the different frequency curves 804a-d. Thus, with each different frequency shift some new data points are obtained in the frequency domain.

For slow sample rates (relative to the transform rate) each in-between point of the sine wave signal is taken from the signal itself, provided a circular buffer is used, by shifting the analysis frequency (Figure 8), therefore exactly displaying the signal. For slow sample rates (relative to the transform rate) and in one possible embodiment, the same data points may be used to generate successive outputs, with each input data set now shifted in frequency. For fast sample rates (relative to the transform rate), some or all of the input data points may be new such that different data points are used to generate successive outputs, with each input data set now shifted in frequency. This works due to the fact that a sine wave signal remains the same for all acquisitions.

After the acquisitions are processed, the samples are shifted back in frequency to their proper place to fill in the display as shown in Figure 9. Figure 9 is a frequency spectrum illustrating the samples being shifted back to the original frequency and resultant single tone 902.

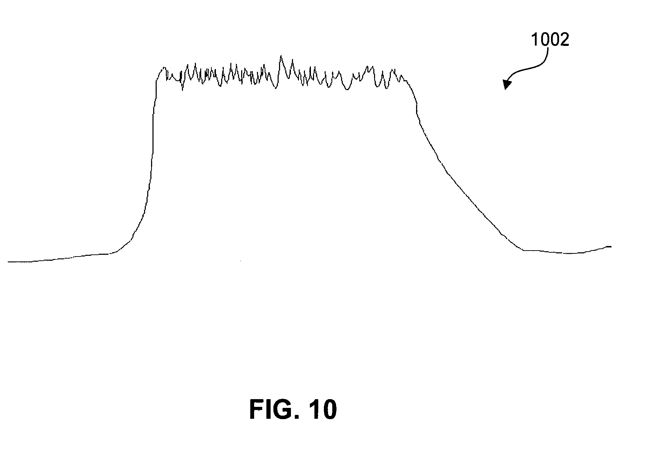

Figure 10 is a frequency spectrum illustrating the display 1002 for a noise-like signal. For noise-like signals like Figure 10, the actual points found are not replicating the missing points in the first acquisition, but are indeed all points that are gathered from acquisitions of the same signal, therefore they all share the same statistical amplitude probability as the first acquisition. This preserves the noise statistics of the combined end-result display as illustrated in Figure 10.

Information and signals may be represented using any of a variety of different technologies and techniques. For example, data, instructions, commands, information, signals, bits, symbols, and chips that may be referenced throughout the above description may be represented by voltages, currents, electromagnetic waves, magnetic fields or particles, optical fields or particles, or any combination thereof.

The various illustrative logical blocks, modules, circuits, and algorithm steps described in connection with the embodiments disclosed herein may be implemented as electronic hardware, computer software, or combinations of both. To clearly illustrate this interchangeability of hardware and software, various illustrative components, blocks, modules, circuits, and steps have been described above generally in terms of their functionality. Whether such functionality is implemented as hardware or software depends upon the particular application and design constraints imposed on the overall system. Skilled artisans may implement the described functionality in varying ways for each particular application, but such implementation decisions should not be interpreted as causing a departure from the scope of the present invention.

The various illustrative logical blocks, modules, and circuits described in connection with the embodiments disclosed herein may be implemented or performed with a general purpose processor, a digital signal processor (DSP), an application specific integrated circuit (ASIC), a field programmable gate array signal (FPGA) or other programmable logic device, discrete gate or transistor logic, discrete hardware components, or any combination thereof designed to perform the functions described herein. A general purpose processor may be a microprocessor, but in the alternative, the processor may be any conventional processor, controller, microcontroller, or state machine. A processor may also be implemented as a combination of computing devices, e.g., a combination of a DSP and a microprocessor, a plurality of microprocessors, one or more microprocessors in conjunction with a DSP core, or any other such configuration.

The steps of a method or algorithm described in connection with the embodiments disclosed herein may be embodied directly in hardware, in a software module executed by a processor, or in a combination of the two. A software module may reside in RAM memory, flash memory, ROM memory, EPROM memory, EEPROM memory, registers, hard disk, a removable disk, a CD-ROM, or any other form of storage medium known in the art. An exemplary storage medium is coupled to the processor such that the processor can read information from, and write information to, the storage medium. In the alternative, the storage medium may be integral to the processor. The processor and the storage medium may reside in an ASIC. The ASIC may reside in a user terminal. In the alternative, the processor and the storage medium may reside as discrete components in a user terminal.

The methods disclosed herein comprise one or more steps or actions for achieving the described method. The method steps and/or actions may be interchanged with one another without departing from the scope of the present invention. In other words, unless a specific order of steps or actions is required for proper operation of the embodiment, the order and/or use of specific steps and/or actions may be modified without departing from the scope of the present invention.

While specific embodiments and applications of the present invention have been illustrated and described, it is to be understood that the invention is not limited to the precise configuration and components disclosed herein. Various modifications, changes, and variations which will be apparent to those skilled in the art may be made in the arrangement, operation, and details of the methods and systems of the present invention disclosed herein without departing from the spirit and scope of the invention.

## Claims

1. A method for time domain to frequency domain conversion comprises:

   obtaining time-domain input data;
   converting the input data from the time domain to the frequency domain to provide frequency-domain data;
   producing frequency-shifted time-domain data;
   converting the frequency shifted time-domain data from the time domain to the frequency domain to provide frequency-shifted frequency-domain data;
   combining the frequency-domain data with the frequency-shifted frequency-domain data to produce combined frequency-domain data; and
   providing the frequency-domain data for further processing by a test and measurement system.

2. The method of claim 1, wherein producing frequency-shifted time-domain data comprises shifting the frequency of the time-domain input data.

3. The method of claim 1, wherein producing frequency-shifted time-domain data comprises shifting the frequency of a second set of time-domain input data.

4. The method of claim 3, wherein the second set of time-domain input data comprises a portion of the time-domain input data.

5. The method of claim 1, further comprising digitizing an input signal to obtain the time-domain input data.

6. The method of claim 1, wherein obtaining the time-domain input data comprises reading the data in from a computer-readable file.

7. The method of claim 1, wherein the converting from the time domain to the frequency domain is accomplished using a Discrete Fourier Transform.

8. The method of claim 1, wherein producing frequency-shifted time-domain data is accomplished using a numerically controlled oscillator.

9. The method of claim 8, wherein producing frequency-shifted time-domain data is accomplished by multiplying the input data by an output from the numerically controlled oscillator.

10. The method of claim 1, further comprising windowing the frequency-shifted time-domain data before converting the frequency-shifted time-domain data from the time domain to the frequency domain.

11. The method of claim 1, further comprising iteratively performing producing frequency-shifted time-domain data, converting the frequency-shifted time-domain data; and combining the frequency-domain data with frequency-shifted frequency-domain data, wherein the combined frequency-domain data is stored as frequency domain data.

12. The method of claim 11, wherein producing frequency-shifted time-domain data comprises shifting the frequency by a frequency offset.

13. The method of claim 12, wherein the frequency offset changes with each iteration.

14. The method of claim 13, wherein the frequency offset is pseudo-random.

15. The method of claim 12, wherein the frequency offset is determined based on a desired number of data points to be added in between frequency bins.

16. The method of claim 1, wherein the method produces a number of sets of frequency-shifted frequency-domain data, and wherein the method uses all or any portion of the frequency-domain data to perform the further processing.

17. The method of claim 1, further comprising performing a plurality of producing frequency-shifted time-domain data steps to produce a plurality of frequency-shifted time-domain data sets, and converting the plurality frequency-shifted time-domain data sets to produce a plurality of frequency shifted frequency domain data sets; prior to combining the frequency-domain data with the plurality of frequency-shifted frequency-domain data sets, wherein the combined frequency-domain data is provided as the frequency domain data.

18. The method of claim 1, wherein further processing comprises providing a display on the test and measurement system.

19. The method of claim 1, wherein further processing comprises performing measurements using the frequency-domain data.

20. An apparatus for time domain to frequency domain conversion, the apparatus comprising:

   a processor;
   memory in electronic communication with the processor;
   obtaining instructions stored in the memory, the obtaining instructions being executable by the processor to obtain time-domain input data;

converting instructions stored in the memory, the converting instructions being executable by the processor to convert the input data from the time domain to the frequency domain to provide frequency-domain data;

producing instructions stored in the memory, the producing instructions being executable by the processor to produce frequency-shifted time-domain data;

second converting instructions stored in the memory, the second converting instructions being executable by the processor to convert the frequency shifted time-domain data from the time domain to the frequency domain to provide frequency-shifted frequency-domain data;

combining instructions stored in the memory, the combining instructions being executable by the processor to combine the frequency-domain data with the frequency-shifted frequency-domain data to produce combined frequency-domain data; and

providing instructions stored in the memory, the providing instructions being executable by the processor to provide the frequency-domain data for further processing by a test and measurement system.

21. The apparatus of claim 20, wherein further processing comprises providing a display on the test instrument.

22. The apparatus of claim 20, wherein further processing comprises performing measurements using the frequency-shifted frequency-domain data.

23. The apparatus of claim 20, wherein the apparatus produces a number of sets of frequency-shifted frequency-domain data, and wherein the method uses all or any portion of the frequency-domain data to perform the further processing.

24. The apparatus of claim 20, wherein the converting instructions convert from the time domain to the frequency domain using a Discrete Fourier Transform.

25. The apparatus of claim 20, wherein the producing instructions produce frequency-shifted time-domain data using a numerically controlled oscillator.

26. A real-time spectrum analyzer for time domain to frequency domain conversion, the analyzer comprising:

an input interface for continuously obtaining an input signal;

an analog to digital converter for continuously converting the input signal into input data;

a processor;

memory in electronic communication with the processor;

at least one digital signal processor for performing digital signal processing functions in electronic communication with the processor;

obtaining instructions stored in the memory, the obtaining instructions being executable by the processor or the digital signal processor to obtain time-domain input data;

converting instructions stored in the memory, the converting instructions being executable by the processor or the digital signal processor to convert the input data from the time domain to the frequency domain to provide frequency-domain data;

producing instructions stored in the memory, the producing instructions being executable by the processor or the digital signal processor to produce frequency-shifted time-domain data;

second converting instructions stored in the memory, the second converting instructions being executable by the processor or the digital signal processor to convert the frequency shifted time-domain data from the time domain to the frequency domain to provide frequency-shifted frequency-domain data;

combining instructions stored in the memory, the combining instructions being executable by the processor or the digital signal processor to combine the frequency-domain data with the frequency-shifted frequency-domain data to produce combined frequency-domain data; and

providing instructions stored in the memory, the providing instructions being executable by the processor or the digital signal processor to provide the frequency-domain data for further processing by a test and measurement system.

27. An apparatus for time domain to frequency domain conversion, the apparatus comprising:

processing logic;

memory in electronic communication with the processing logic;

obtaining logic, the obtaining logic being operable to obtain time-domain input data;

converting logic, the converting logic being operable to convert the input data from the time domain to the frequency domain to provide frequency-domain data;
producing logic, the producing logic being operable to produce frequency-shifted time-domain data;
second converting logic, the second converting logic being operable to convert the frequency shifted time-domain data from the time domain to the frequency domain to provide frequency-shifted frequency-domain data;
combining logic, the combining logic being operable to combine the frequency-domain data with the frequency-shifted frequency-domain data to produce combined frequency-domain data; and
providing logic, the providing logic being operable to provide the frequency-domain data for further processing by a test and measurement system.

28. The apparatus of claim 27, further comprising:

a display screen; and
display logic, the display logic being operable to use the frequency-shifted frequency-domain data to provide a display on the display screen of the apparatus.

102

104

106

Prior
Art

108d

108c

108a     108b

106

108m      108n

F1  F2

**FIG. 1**

204     204

208c

206        206

202

208b

208a

208n

208o

Prior Art

**FIG. 2**

300

| Input Signal<br>(Time Domain) | Tunable<br>Frequency<br>Conversion<br>Stage<br>*310* | Frequency-Shifted<br>Input Signal<br>(Time Domain) | DFT<br>*316* |

312

314

318

Frequency
Setting

# FIG. 3

400

402 — Obtain an input signal in the time domain

404 — Digitize the input signal to provide a digital input signal

406 — Adjust tunable frequency conversion stage

408 — Shift the frequency of the digital input signal using the tunable frequency conversion stage

410 — Convert from the time-domain to the frequency domain

412 — Use the frequency domain data to provide a graphical display to a user

**FIG. 4**

500

526

Input
Signal

| ADC 522 | → | Input Buffer 524 |

⊗

| Window 528 | → | DFT 516 | → | Display 530 |

512

Numerically
Controlled Oscillator
520

518

F

**FIG. 5**

602

Test Equipment

```
┌─────────────────┐   ┌─────────────────┐   ┌─────────────────┐
│ Memory 604      │   │                 │   │                 │
│  ┌───────────┐  │   │ Data            │   │ Output          │
│  │ System    │  │   │ Acquisition     │   │ Devices 609     │
│  │ 600       │  │   │ Units 632       │   │                 │
│  └───────────┘  │   │                 │   │                 │
└─────────────────┘   └─────────────────┘   └─────────────────┘
```

614

```
┌─────────────────┐   ┌─────────────────┐   ┌─────────────────┐
│ Comm.           │   │                 │   │                 │
│ Interface       │   │ Processor       │   │ Transceiver     │
│ 605             │   │ 603             │   │ 608             │
│                 │   │                 │   │                 │
└─────────────────┘   └─────────────────┘   └─────────────────┘
```

```
┌─────────────────┐   ┌─────────────────┐   ┌─────────────────┐
│                 │   │ Digital Signal  │   │                 │
│ Input Devices   │   │ Processing      │   │ Display 611     │
│ 607             │   │ Units 634       │   │                 │
│                 │   │                 │   │                 │
└─────────────────┘   └─────────────────┘   └─────────────────┘
```

## FIG. 6

702

748

RF Down
Converter

| Low Pass Filter _740_ | | IF Filter _744_ | ADC _746_ | DSP _750_ |

Memory _754_

System _700_

742

704

Trigger _752_

| Frequency Domain View _756_ | Time Domain View _758_ | Modulation Analysis View _760_ | Spectrogram View _762_ | Codogram View _764_ |

FIG. 7

802

804a
804b

804c
804d

**FIG. 8**

902

**FIG. 9**

1002

**FIG. 10**